# EUROPÄISCHE PATENTSCHRIFT

(11) **EP 0 714 121 B1**
(45) Veröffentlichungstag und Bekanntmachung des Hinweises auf die Patenterteilung: **28.06.2000**
(21) Anmeldenummer: 95118213.8
(22) Anmeldetag: 17.11.1995
(51) Int. Cl.: H01L 21/3205

(54) **Korrosionsschutz für mikromechanische Metallschichten**
Corrosion protection for micromechanical metallic layers
Protection contre la corrosion pour couches métalliques micromécaniques

(30) Priorität: 24.11.1994 DE 4441900
(43) Veröffentlichungstag der Anmeldung: 29.05.1996
(73) Patentinhaber: SIEMENS AKTIENGESELLSCHAFT, 80333 München (DE)
(72) Erfinder: Näher, Ulrich, Dr., D-80803 München (DE); Bertagnolli, Emmerich, Dr., D-80799 München (DE)

(56) Entgegenhaltungen:
- WO-A-91/05284
- PROCEEDINGS OF THE WORKSHOP ON MICRO ELECTRO MECHANICAL SYSTEMS (ME, FORT LAUDERDALE, FEB. 7 - 10, 1993, Nr. WORKSHOP 6, 7.Februar 1993, INSTITUTE OF ELECTRICAL AND ELECTRONICS ENGINEERS, Seiten 155-159, XP000366873 SHAW K A ET AL: "SCREAM I: A SINGLE MASK, SINGLE-CRYSTAL SILICON PROCESS FOR MICROELECTROMECHANICAL STRUCTURES"

## Beschreibung

Die monolithische Integration von Bauelementen mit mikromechanischen Oberflächenstrukturen zusammen mit elektronischen Bauelementen für Ansteuer- und Meßschaltungen auf einem Chip und die Herstellung im Rahmen desselben Prozesses bringen erhebliche Vorteile in bezug auf Performance, Zuverlässigkeit, Miniaturisierung und Kosten dieser Bauteile.

Mikromechanische Sensor- und Aktuatorstrukturen werden durch das Freiätzen von Membranen, Schwingern und dgl. hergestellt, indem unter dafür vorgesehene Schichten Hohlräume geätzt werden. Insbesondere diese Ätzprozesse stellen dabei verglichen mit herkömmlichen Verfahren völlig neue Anforderungen an die Selektivität der Ätzmittel.

Beim Ätzen von Hohlräumen unter einer Metallschicht (insbesondere z. B. bei Aluminium oder einer Aluminiumlegierung), einem Verfahrensschritt, wie er bei der Herstellung von freitragenden Membranen häufig auftritt, muß eine unter einer dünnen Metallschicht befindliche Opferschicht zumindest bereichsweise entfernt werden. Als Opferschicht (sacrificial layer) wird im allgemeinen Siliziumoxid, z. B. Borphosphorsilikatglas, oder eine andere Siliziumverbindung verwendet. Es tritt das Problem auf, daß ein Ätzprozeß, der selektiv Siliziumoxid ätzt gleichzeitig das Metall der für die Membran vorgesehenen Metallschicht angreift. Für viele Metalle, insbesondere Aluminiumlegierungen, gibt es keinen Ätzprozeß, der isotrop Siliziumoxid ätzt, das Metall aber nicht angreift. In vielen Fällen ist daher das Freiätzen der Metallschichten durch Ätzen von Hohlräumen in Opferschichten aus Siliziumoxid nicht ohne gleichzeitige Korrosion des Metalls möglich.

Aufgabe der vorliegenden Erfindung ist es, eine Möglichkeit anzugeben, wie mikromechanische Strukturen aus Metall korrosionsfrei freigeätzt werden können.

Diese Aufgabe wird mit dem Bauelement mit den Merkmalen des Anspruches 1 und mit dem Herstellungsverfahren mit den Merkmalen des Anspruches 4 gelöst. Weitere Ausgestaltungen ergeben sich jeweils aus den abhängigen Ansprüchen.

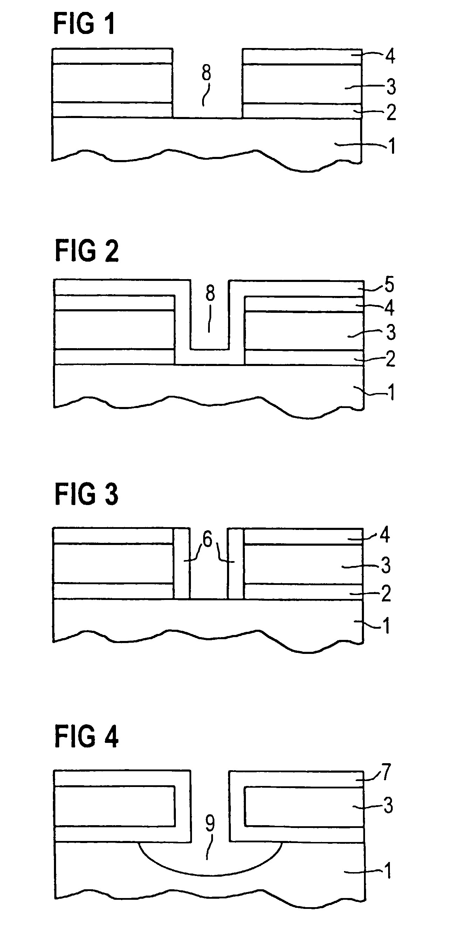

Bei der erfindungsgemäßen Lösung wird die mikromechanische Struktur aus Metall mit einer Schutzschicht umgeben, die gegen den chemischen Stoff, der zum Ätzen einer Opferschicht verwendet wird, resistent ist. Dieses Bauelement und das zugehörige Herstellungsverfahren werden im einzelnen anhand der Figuren 1 bis 4 erläutert, die Zwischenstufen eines erfindungsgemäßen Bauelementes nach verschiedenen Schritten des Herstellungsverfahrens zeigen. In den Figuren ist der Übersichtlichkeit halber die seitliche Wand eines Ätzloches 8 bzw. eines geätzten Hohlraumes 9 in der Blickrichtung weggelassen.

Bei dem erfindungsgemäßen Bauelement entsprechend der Figur 4 ist eine Metallschicht 3 über einer Opferschicht 1 aufgebracht. Durch ein Ätzloch ist in der Opferschicht 1 ein Hohlraum 9 geätzt, um einen Teil der Metallschicht 3 als Membran oder dgl. freizulegen. Dieser Anteil der Metallschicht 3 ist dann in einem Abstand zu dem restlichen Anteil des Bauelementes angeordnet. Um das Metall gegen den Ätzangriff beim Ausätzen der Opferschicht zu schützen, ist rings um die Metallschicht 3 auf deren Oberseiten eine Schutzschicht 7 aufgebracht, die gegen das Ätzmittel resistent ist. Auf diese Weise können die mikromechanischen Strukturen, die zumindest auf den freizulegenden Oberseiten mit dieser Schutzschicht 7 versehen sind, korrosionsfrei freigeätzt werden.

Dieses Bauelement wird z. B. hergestellt, indem auf eine Opferschicht 1, die z. B. Siliziumoxid, Siliziumdioxid oder eine andere Siliziumverbindung sein kann, eine untere Schutzschicht 2 zumindest in dem für die Metallschicht vorgesehenen Bereich aufgebracht wird. Darauf werden die Metallschicht 3 und eine obere Schutzschicht 4 aufgebracht, so daß die in Figur 1 gezeichnete Schichtfolge vorhanden ist. Das Material der unteren Schutzschicht 2 und der oberen Schutzschicht 4 wird dabei so gewählt, daß beim Ausätzen der Opferschicht 1 das dafür vorgesehene Ätzmittel diese Schutzschichten nicht oder nur unwesentlich angreift. Die Dicke der Schutzschichten wird dabei so bemessen, daß in jedem Fall die Metallschicht 3 während des Ätzprozesses von den Schutzschichten bedeckt bleibt.

Um unter der Metallschicht 3 einen Hohlraum in die Opferschicht 1 ätzen zu können, wird mindestens ein, vorzugsweise mehrere Ätzlöcher 8 in diese Schichtfolge aus der Metallschicht und den beiden Schutzschichten geätzt. Ein Ätzloch 8 hat einen Durchmesser von z. B. etwa 1 µm. An den Wänden des Ätzloches 8 ist die Metallschicht 3 freigelegt und kann dort von einem Ätzmittel angegriffen werden. Um das zu verhindern, wird eine ergänzende Schutzschicht 5, wie sie in Figur 2 eingezeichnet ist, konform abgeschieden, so daß sie als Schicht die Oberfläche der oberen Schutzschicht 4 und die Wände und den Boden des Ätzloches 8 bedeckt. Das Material dieser ergänzenden Schutzschicht 5 wird ebenfalls so gewählt, daß es von dem für das Ätzen des Hohlraumes in der Opferschicht 1 vorgesehenen chemischen Stoff nicht oder nur unwesentlich angegriffen wird. Es muß dann der Boden des Ätzloches wieder von dieser ergänzenden Schutzschicht 5 befreit werden, um die Oberfläche der Opferschicht 1 hier wieder freizulegen. Das kann z. B. dadurch erfolgen, daß anisotrop die ergänzende Schutzschicht rückgeätzt wird, wobei an den seitlichen Wänden des Ätzloches 8 ein restlicher Anteil 6 (s. Figur 3) dieser ergänzenden Schutzschicht 5 stehenbleibt. Dieser restliche Anteil 6 der ergänzenden Schutzschicht bildet zusammen mit der unteren Schutzschicht 2 und der oberen Schutzschicht 4 die in Figur 4 eingezeichnete, die Oberfläche der Metallschicht 3 umgebende Schutzschicht 7. Auf diese Weise ist die Metallschicht 3 gegen das Ätzmittel geschützt, das dann angewendet wird, um in der Opferschicht 1 den Hohlraum 9 auszuätzen. Dieser Hohlraum 9 wird so groß ausgeätzt, daß derjenige Anteil der Metallschicht 3, der die Membran oder das schwingende Element bilden soll, von dem restlichen Anteil des Bauelementes durch einen hinreichend großen Abstand getrennt ist.

Besonders vorteilhaft sind Ausführungsbeispiele des erfindungsgemäßen Bauelementes und Verfahrens, die im Rahmen der Standardprozesse der Herstellung von integrierten mikromechanischen Bauelementen in Silizium hergestellt werden können. Als Metallschicht wird insbesondere z. B. eine Aluminiumschicht oder eine Schicht aus einer Aluminiumlegierung verwendet. Diese für die mikromechanische Struktur vorgesehene Metallschicht wird üblicherweise zwischen dünnen Schichten aus TiN eingeschlossen. Diese Schichten sind z. B. ca. 50 nm dick. Die untere Schicht dient dabei als Diffusionsbarriere für das in Kontaktlöcher eingebrachte Metall. Die obere Schicht dient als Antireflex-Schicht für eine nachfolgende Fototechnik. Diese Schichten können als untere Schutzschicht und als obere Schutzschicht bei dem erfindungsgemäßen Bauelement verwendet werden. Die obere Schicht aus TiN sollte dabei z. B. ca. 30 nm dicker ausgebildet werden, als es für eine Antireflexschicht erforderlich wäre. Das TiN ist resistent gegen Flußsäure (HF). Mit HF (z. B. im Verhältnis 5:1 mit Ammoniumfluorid gepuffert) kann Siliziumdioxid geätzt werden, das z. B. als Material für die Opferschicht 1 verwendet wird.

Nach der Abscheidung der oberen Schutzschicht 4 werden Ätzlöcher 8 anisotrop in die Schichtfolge geätzt. Das kann bei den angegebenen Materialien z. B. mit RIE (Reactive Ion Etching) unter Verwendung von BCl₃ oder Cl₂ erfolgen. Als ergänzender Prozeßschritt wird dann die ergänzende Schutzschicht 5 z. B. als eine z. B. ca. 50 nm dicke Schicht aus z. B. TiN konform abgeschieden, wobei ein verwendeter CVD-Prozeß (chemical vapor deposition) eine porenfreie Abscheidung gewährleistet. Wegen des vorhandenen Aluminiums muß eine relativ niedrigere Abscheidetemperatur gewählt werden. Mit diesem Verfahrensschritt werden die Innenseiten der Ätzlöcher vollständig mit dem Material der ergänzenden Schutzschicht, in diesem Beispiel TiN, bedeckt. Es ist dann kein Metall der Metallschicht 3 mehr nach außen dem Angriff des Ätzmittels ausgesetzt. Der Boden der Ätzlöcher 8, d. h. der Zugang für die anschließende naßchemische Ätzung des Siliziumdioxids, das in diesem Beispiel das Material der Opferschicht 1 ist, ist allerdings durch diese ergänzende Schutzschicht 5 versperrt. Aus diesem Grund muß die ergänzende Schutzschicht auf dem Boden der Ätzlöcher entfernt werden. Das geschieht am besten, indem diese ergänzende Schutzschicht anisotrop rückgeätzt wird, wobei keine Maskentechnik erforderlich ist. Auf diese Weise bleiben die seitlichen Wände der Ätzlöcher von der Schutzschicht bedeckt, und auf dem Boden der Ätzlöcher wird die Opferschicht freigelegt. Das Siliziumdioxid kann dann z. B. mit einem flüssigen Ätzmittel, wie z. B. Flußsäure, entfernt werden, wobei die Metallschicht 3 durch die Schutzschicht 7 ringsum gegen den Ätzangriff geschützt ist.

Damit stellt der hier beschriebene erfindungsgemäße Herstellungsprozeß ein einfaches Verfahren dar, mikromechanische Strukturen aus Metall freizuätzen, ohne daß das Metall dabei angegriffen wird. Die erfindungsgemäße Struktur des Bauelementes und dieses Verfahren lassen sich in den Prozeßablauf der Herstellung integrierter mikromechanischer Sensoren oder Aktuatoren auf einfache Weise einfügen.

## Patentansprüche

1. Verfahren zur Herstellung eines mikromechanischen Bauelementes mit einer für einen Sensor oder Aktuator vorgesehenen Metallschicht (3), bei dem
a) auf eine Opferschicht (1) eine untere Schutzschicht (2) aus einem Material, das gegen den zum Entfernen dieser Opferschicht vorgesehenen chemischen Stoff resistent ist, aufgebracht wird,
b) auf diese untere Schutzschicht die Metallschicht (3) aufgebracht wird,
c) auf diese Metallschicht eine obere Schutzschicht (4) aus einem Material, das gegen den zum Entfernen dieser Opferschicht vorgesehenen chemischen Stoff resistent ist, aufgebracht wird,
d) mindestens ein Ätzloch (8) in diese obere Schutzschicht, diese Metallschicht und diese untere Schutzschicht anisotrop geätzt wird,
e) eine ergänzende Schutzschicht (5) aus einem Material, das gegen den zum Entfernen dieser Opferschicht vorgesehenen chemischen Stoff resistent ist, konform abgeschieden wird, so daß die Metallschicht vollständig bedeckt ist,
f) diese ergänzende Schutzschicht soweit anisotrop rückgeätzt wird, daß die Opferschicht in dem Ätzloch freigelegt ist und die Metallschicht vollständig bedeckt bleibt, und
g) durch das Ätzloch hindurch die Opferschicht ausgeätzt wird.

2. Verfahren nach Anspruch 1, bei dem
als Metallschicht eine Schicht aus Aluminium oder einer Aluminiumlegierung aufgebracht wird.

3. Verfahren nach Anspruch 1 oder 2, bei dem
eine Opferschicht (1), die Silizium enthält, verwendet wird und
in den Schritten a) und c) die untere Schutzschicht (2) und die obere Schutzschicht (4) aus TiN hergestellt werden.

4. Verfahren nach einem der Ansprüche 1 bis 3, bei dem
in den Schritten a), c) und e) die untere Schutzschicht (2), die obere Schutzschicht (4) und die ergänzende Schutzschicht (5) aus demselben Material aufgebracht werden.

5. Verfahren nach einem der Ansprüche 1 bis 4, bei dem
als Opferschicht ein Siliziumoxid verwendet wird und
in Schritt g) ein flüssiger Ätzstoff, der HF enthält, verwendet wird.

## Claims

1. Process for the production of a micromechanical component with a metal layer (3) intended for a sensor or actuator, in which
a) a lower protective layer (2) of a material which is resistant to the chemical substance intended to remove a sacrificial layer (1) is applied to this sacrificial layer,
b) the metal layer (3) is applied to this lower protective layer,
c) an upper protective layer (4) of a material which is resistant to the chemical substance intended to remove this sacrificial layer is applied to this metal layer,
d) at least one etching hole (8) is anisotropically etched into this upper protective layer, this metal layer and this lower protective layer,
e) a supplementary protective layer (5) of a material which is resistant to the chemical substance intended to remove this sacrificial layer, is conformally deposited so that the metal layer is fully covered,
f) this supplementary protective layer is etched back anisotropically to the extent that the sacrificial layer in the etching hole is exposed and the metal layer remains fully covered, and
g) the sacrificial layer is etched away through the etching hole.

2. Process according to Claim 1, in which a layer of aluminium or of an aluminium alloy is applied as the metal layer.

3. Process according to Claim 1 or 2, in which a sacrificial layer (1) which contains silicon is used, and in steps a) and c) the lower protective layer (2) and the upper protective layer (4) are made from TiN.

4. Process according to one of Claims 1 to 3, in which in steps a), c) and e) the lower protective layer (2), the upper protective layer (4) and the final protective layer (5) are applied using the same material.

5. Process according to one of Claims 1 to 4, in which a silicon oxide is used as the sacrificial layer, and in step g) a liquid etchant which contains HF is used.

## Revendications

1. Procédé pour la fabrication d'un composant micromécanique avec une couche de métal (3) prévue pour un détecteur ou un actionneur au cours duquel
a) est appliquée, sur une couche sacrificielle (1), une couche inférieure de protection (2), composée d'un matériau qui résiste au produit chimique prévu pour enlever cette couche sacrificielle,
b) est appliquée, sur cette couche inférieure de protection, la couche de métal (3),
c) est appliquée, sur cette couche de métal, une couche supérieure de protection (4), composée d'un matériau qui résiste au produit chimique prévu pour enlever cette couche sacrificielle,
d) au moins un trou de gravure (8) est gravé, d'une façon anisotrope, dans cette couche supérieure de protection, cette couche de métal et cette couche inférieure de protection,
e) une couche complémentaire de protection (5), composée d'un matériau qui résiste au produit chimique prévu pour enlever cette couche sacrificielle, est déposée, d'une façon conforme, de telle sorte que la couche de métal est entièrement recouverte,
f) cette couche complémentaire de protection est décapée de nouveau, d'une façon anisotrope, jusqu'à ce que la couche sacrificielle soit mise à découvert dans le trou de gravure, mais de telle sorte que la couche de métal reste entièrement recouverte et
g) la couche sacrificielle est dégagée à travers le trou de gravure.

2. Procédé selon la revendication 1 au cours duquel
une couche d'aluminium ou d'un alliage d'aluminium est déposée en tant que couche de métal.

3. Procédé selon la revendication 1 ou 2 au cours duquel
on utilise une couche sacrificielle (1) qui contient du silicium et,
pour les étapes a) et c), la couche inférieure de protection (2) et la couche supérieure de protection (4) est réalisée en TiN.

4. Procédé selon l'une des revendications 1 à 3 au cours duquel,
pour les étapes a), c) et e), la couche inférieure de protection (2), la couche supérieure de protection (4) et la couche complémentaire de protection (5) sont composées du même matériau.

5. Procédé selon l'une des revendications 1 à 4 au cours duquel
sont utilisés un oxyde de silicium comme couche sacrificielle et, pour l'étape g), un agent de gravure liquide qui contient de l'acide fluorhydrique.
